# EUROPEAN PATENT APPLICATION

(11) **EP 4 553 892 A1**
(43) Date of publication of application: **14.05.2025**
(21) Application number: 23209499.5
(22) Date of filing: 13.11.2023
(51) Int. Cl.: H01L 23/31, H01L 23/495

(54) **LEADFRAME PACKAGE WITH INCREASED ROUTING CAPABILITY**

(71) Applicant: Infineon Technologies Austria AG, 9500 Villach (AT)
(72) Inventor: ZHUANG, Hao, 85662 Hohenbrunn (DE); MOSTOFIZADEH, Milad, 81673 München (DE); HÖGLAUER, Josef, 85551 Kirchheim-Heimstetten (DE); OTREMBA, Ralf, 87600 Kaufbeuren (DE); RIOS, Margie Tumulak, 75200 Melaka (MY)
(74) Representative: Lambsdorff & Lange Patentanwälte Partnerschaft mbB

(57) **Abstract**

A semiconductor chip package includes a semiconductor chip having a first side and a second side opposite the first side. The first side includes chip pads. The semiconductor chip package includes a first leadframe structured to form a footprint of the semiconductor chip package. The semiconductor chip package further includes a structured metal plate disposed between the first leadframe and the semiconductor chip, wherein the first side of the semiconductor chip faces the structured metal plate. A pattern of bond material is disposed between the first leadframe and the structured metal plate. The pattern of bond material is configured to electrically and mechanically connect structures of the first leadframe to structures of the structured metal plate. The semiconductor chip package includes a mold compound embedding the first leadframe, the structured metal plate and the semiconductor chip.

## Description

### Technical Field

This disclosure relates generally to the technique of semiconductor packaging, and in particular to a leadframe package.

### Background

Packaging techniques can have a high impact on device performance. Packaging concepts may aim to provide a high routing capability, a high variability of footprint design, a good board level reliability (e.g., high thermal cycling on board (TCoB) performance) and good thermal dissipation into the board as well as low assembly cost. Moreover, in particular for power applications, the packaging concept should provide for low package inductance and low spreading resistance in the board routing, which are disadvantageous for the customer because they may not be able to enjoy the low R_{DS(on)} of a power transistor device, for example.

To overcome some of the above drawbacks, laminate-based package solutions are used. By doing so, the footprint design of the device is no longer limited by the pad layout of the chip. However, the usage of laminate in packaging leads to higher package cost and limitations in terms of solder materials which can be used. Further, due to the relatively low metal thickness of the redistribution layer in the laminate, low package resistances are difficult to obtain.

### Summary

According to an aspect of the disclosure, a semiconductor chip package includes a semiconductor chip having a first side and a second side opposite the first side, wherein the first side comprises chip pads. The semiconductor chip package includes a first leadframe structured to form a footprint of the semiconductor chip package. The semiconductor chip package further includes a structured metal plate disposed between the first leadframe and the semiconductor chip, wherein the first side of the semiconductor chip faces the structured metal plate. A pattern of bond material is disposed between the first leadframe and the structured metal plate, wherein the pattern of bond material is configured to electrically and mechanically connect structures of the first leadframe to structures of the structured metal plate. The semiconductor chip package further includes a mold compound embedding the first leadframe, the structured metal plate and the semiconductor chip.

According to another aspect of the disclosure, a method of manufacturing a semiconductor chip package includes bonding a first leadframe structured to form a footprint of the semiconductor chip package to a second leadframe structured to align with chip pads of a semiconductor chip. A semiconductor chip having a first side and a second side opposite the first side, wherein the first side comprises chip pads, is attached with the chip pads to the second leadframe. The first leadframe, the second leadframe and the semiconductor chip are embedded in a mold compound.

According to another aspect of the disclosure, a method of manufacturing a semiconductor chip package includes attaching a semiconductor chip having a first side and a second side opposite the first side, wherein the first side comprises chip pads, with the chip pads to a second leadframe. The second leadframe and the semiconductor chip are embedded in a mold compound. A first leadframe structured to form a footprint of the semiconductor chip package is bonded to the second leadframe.

According to another aspect of the disclosure, a method of manufacturing a semiconductor chip package includes bonding a first leadframe structured to form a footprint of the semiconductor chip package to a metal plate. The first leadframe is embedded in a pre-mold compound. The metal plate is structured to provide a structured metal plate. A semiconductor chip having a first side and a second side opposite the first side, wherein the first side comprises chip pads, is attached with the chip pads to the structured metal plate. The first leadframe, the structured metal plate and the semiconductor chip are embedded in a mold compound.

### Brief description of the drawings

In the drawings, like reference numerals designate corresponding similar parts. The features of the various illustrated embodiments can be combined unless they exclude each other and/or can be selectively omitted if not described to be necessarily required. Embodiments are depicted in the drawings and are exemplarily detailed in the description which follows.
Figure 1 is a perspective explosion view of an example of a semiconductor chip package without mold compound.
Figure 2 is a plan view on a first side of an example of a semiconductor chip illustrating an exemplary layout of source, drain and gate pads.
Figure 3 is a perspective view on the footprint side of an example of a semiconductor chip package.
Figure 4 is a perspective explosion view of an example of a semiconductor chip package without mold compound, the chip package including a plurality of semiconductor chips.
Figure 5 is a perspective view on the footprint side of an example of a semiconductor chip package including a plurality of semiconductor chips.
Figure 6 illustrates exemplary stages of a method of manufacturing a semiconductor chip package using forming a stack including multiple leadframes and molding.
Figure 7 illustrates exemplary stages of a method of manufacturing a semiconductor chip package using pre-molding of a stack including multiple leadframes.
Figure 8 illustrates exemplary stages of a method of manufacturing a semiconductor chip package using molding of a stack including a leadframe and a semiconductor chip.
Figure 9 illustrates exemplary stages of a method of manufacturing a semiconductor chip package using forming a stack including a leadframe and a metal plate and structuring the metal plate.

### Detailed description

As used in this specification, the terms "electrically connected" or "electrically coupled" or similar terms are not meant to mean that the elements are directly contacted together; intervening elements may be provided between the "electrically connected" or "electrically coupled" elements, respectively. However, in accordance with the disclosure, the above-mentioned and similar terms may, optionally, also have the specific meaning that the elements are directly contacted together, i.e. that no intervening elements are provided between the "electrically connected" or "electrically coupled" elements, respectively.

Further, the words "over" or "beneath" with regard to a part, element or material layer formed or located or arranged "over" or "beneath" a surface may be used herein to mean that the part, element or material layer be located (e.g. placed, formed, arranged, deposited, etc.) "directly on" or "directly under", e.g. in direct contact with, the implied surface. The word "over" or "beneath" used with regard to a part, element or material layer formed or located or arranged "over" or "beneath" a surface may, however, either be used herein to mean that the part, element or material layer be located (e.g. placed, formed, arranged, deposited, etc.) "indirectly on" or "indirectly under" the implied surface, with one or more additional parts, elements or layers being arranged between the implied surface and the part, element or material layer.

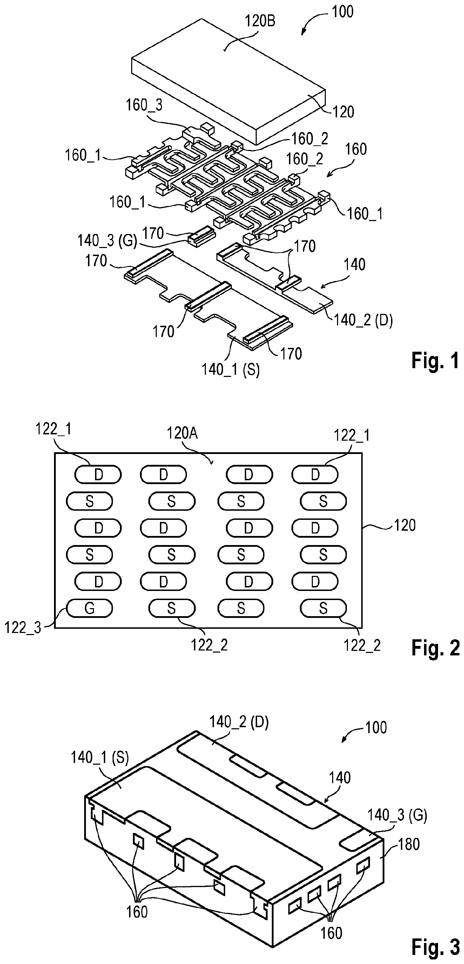

Referring to Figures 1 to 3, a semiconductor chip package 100 includes a semiconductor chip 120. The semiconductor chip 120 has a first side 120A (see Figure 2) and a second side 120B opposite the first side 120A.

The semiconductor chip package 100 further includes a first leadframe 140. The first leadframe 140 is structured to form a footprint of the semiconductor chip package 100.

The semiconductor chip package 100 further includes a structured metal plate 160 disposed between the first leadframe 140 and the semiconductor chip 120. The first side 120A of the semiconductor chip 120 faces the structured metal plate 160.

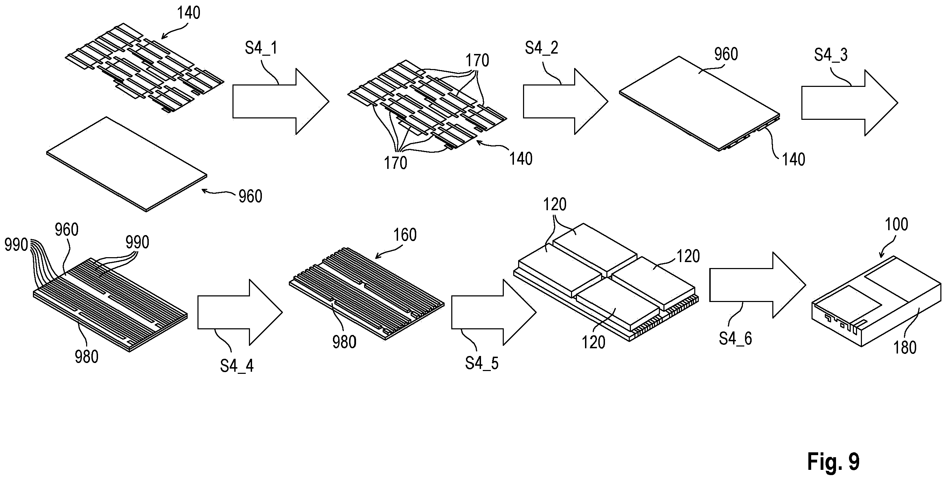

For example, the structured metal plate 160 may be a second leadframe as exemplarily illustrated in Figure 1. However, in other examples (see, e.g., Figure 9), the structured metal plate 160 is not a leadframe.

A pattern of bond material 170 is disposed between the first leadframe 140 and the structured metal plate 160. The pattern of bond material 170 is configured to electrically and mechanically connect structures of the first leadframe 140 to structures of the structured metal plate 160.

As shown in Figure 3, the first leadframe 140, the structured metal plate 160 and the semiconductor chip 120 are embedded in a mold compound 180.

In the following, without loss of generality, the structured metal plate 160 is sometimes referred to as a second leadframe 160, keeping in mind that non-leadframe type structured metal plates 160 may be used as well.

For example, all chip pads of the semiconductor chip may be disposed on the first side 120A of the semiconductor chip 120. Figure 2 shows an exemplary layout of chip pads 122_1, 122_2, 122_3 on the first side 120A of an exemplary semiconductor chip 120. For example, the semiconductor chip 120 may be a transistor chip, e.g. a power transistor chip. For example, the semiconductor chip 120 may be a horizontal device.

The layout of chip pads 122_1, 122_2, 122_3 may include a plurality of source pads (S) 122_2 and a plurality of drain pads (D) 122_1. Further, a gate pad (G) 122_3 may be provided. In the following, the chip pad layout is described by way of example for a power transistor chip 120, e.g. a GaN device. The following description, however, also applies to other semiconductor chips 120 which are not transistor chips and/or are not power devices and/or are not horizontal devices but vertical devices. For example, the disclosure may also encompass IC (integrated circuit) chips, which also provide a plurality of chip pads at a first side 120A of the semiconductor chip 120.

Returning to Figure 2, a plurality of source pads (S) 122_2 may be, e.g., arranged in a number of (horizontal) rows parallel to the longitudinal side of the semiconductor chip 120. Likewise, a plurality of drain pads (D) 122_1 may be arranged in a number of (horizontal) rows parallel to the rows of the source pads (S) 122_2. In the example shown in Figure 2, the rows of source pads (S) 122_2 and the rows of drain pads (D) 122_1 are, e.g., interleaved and/or alternating. In other examples, a plurality (e.g., 2) of the rows of source pads (S) 122_2 and a plurality (e.g., 2) of the rows of drain pads (D) 122_1 may, e.g., be interleaved and/or alternating.

Further, the source pads (S) 122_2 and the drain pads (D) 122_1 may, e.g., be offset from each other in the longitudinal (horizontal) direction. In other examples, the source pads (S) 122_2 and the drain pads (D) 122_1 may, e.g., be aligned to each other in the longitudinal (horizontal) direction. The gate pad (G) 122_3 may be arranged at a corner of the semiconductor chip 120 and may, e.g., be formed by a single gate pad (G).

The (exemplary) layout of chip pads S, D, G apparently needs to be re-routed by a package-internal interconnect in order to provide for a layout of package terminal pads 140_1, 140_2, 140_3 as, e.g., shown in Figure 3. Re-routing is carried out by the second leadframe 160.

The second leadframe 160 (or, more generally, the structured metal plate) may include one or a plurality of first structures 160_1, one or a plurality of second structures 160_2 and one or a plurality of third structures 160_3, for example. In the example shown, the plurality of first structures 160_1 is configured to be connected to the source pads 122_2 of the semiconductor chip 120 and, therefore, to re-route the source load current in the semiconductor chip package 100. In the example shown, the plurality of second structures 160_2 is configured to be connected to the drain pads 122_1 of the semiconductor chip 120 and, therefore, to re-route the drain load current in the semiconductor chip package 100. Further, the third structure 160_3 may be connected to the gate pad 122_3 of the semiconductor chip 120 and may, e.g., be configured to re-route the gate signal in the semiconductor chip package 100.

The pattern of bond material 170, disposed between the first leadframe 140 and the second leadframe 160, electrically connects, e.g., the first structures 160_1 to the first package terminal pad (S) 140_1, the second structures 160_2 to the second package terminal pads (D) 140_2 and the third structure 160_3 to the third package terminal pad (G) 140_3, for example.

The bond material 170 may comprise or be of solder material, conductive adhesive, metal paste, or diffusion solder material. In particular, a solder having a comparatively high reflow temperature such as, e.g., a Pb-based solder can be used.

The higher the reflow temperature of the solder used in the semiconductor chip package 100, the easier is the package assembly at the customer's board. On the other hand, conventional laminate packages require to use lead-free solders such as, e.g., SAC solder (tin-silver-copper-alloy). SAC solder has a lower relatively low reflow temperature and therefore may re-melt at the customer's board assembly, leading to quality issues (package delamination) in conventional laminate-based packages.

As illustrated in Figure 1, the first leadframe 140 may be structured to form a plurality of disconnected longitudinal segments (e.g., the package terminal pads (S) 140_1 and the package terminal pads (D) 140_2) extending in a first lateral direction, whereas the second leadframe (structured metal plate) 160 may be structured to form a plurality of disconnected longitudinal segments (e.g. the first structure 160_1 and the second structure 160_2) extending in a second lateral direction. The first lateral direction and the second lateral direction may be different from each other. The first lateral direction and the second lateral direction may, e.g., be perpendicular to each other. Referring to Figure 1, the first lateral direction may, e.g., be the longitudinal direction of the semiconductor chip package 100, while the second lateral direction may, e.g., be the transverse lateral direction of the semiconductor chip package 100.

In the example shown, the second leadframe 160 is exposed at the sidewall of the package 100. In other examples, the second leadframe 160 may not be exposed at the sidewall of the package 100. Specifically, the second leadframe 160 may, e.g., be completely embedded in (covered by) the mold compound 180. This may facilitate to meet the creepage requirements and can make installation at the customers' site easier.

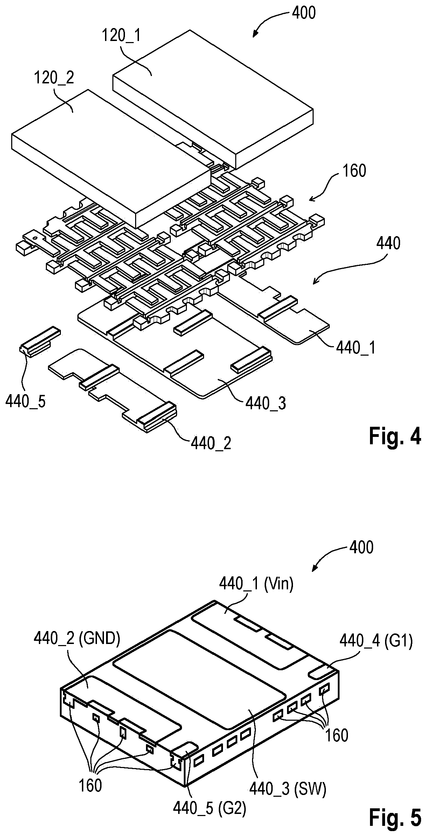

Referring to Figures 4 and 5, an example of a semiconductor chip package 400 may include a plurality of semiconductor chips 120_1, 120_2. The first leadframe 440 may be structured to include a first package terminal pad (Vin) 440_1, a second package terminal pad (GND) 440_2, a third package terminal pad (SW) 440_3, a fourth package terminal pad (G1) 440_4 and a fifth package terminal pad (G2) 440_5. In the example shown, the third package terminal pad (SW) 440_3 is a structure of the first leadframe 440 which is connected via structures of the second leadframe (structured metal plate) 160 to chip pads of the at least two semiconductor chips 120_1, 120_2.

The semiconductor chip package 400 may, e.g., implement a half-bridge circuitry. In a half-bridge circuitry the first package terminal pad 440_1 may be connected to the input voltage Vin, the second package terminal pad 440_2 may be connected to ground (GND) and the third package terminal pad 440_3 may be the switch (SW) node of the circuitry. The fourth package terminal pad 440_4 may be the gate terminal (G1) connecting via a structure of the second leadframe 160 to the gate pad 122_3 of the first semiconductor chip 120_1, and the fifth package terminal pad 440_5 may be a second gate terminal (G2) connecting via a structure of the second leadframe 160 to the gate pad 122_3 of the second semiconductor chip 120_2.

In all examples disclosed herein, the transistor chip(s) 120, 120_1, 120_2 may be, e.g., capable of switching high currents and/or medium voltages or high voltages (e.g., more than 50 V or 100 V or 200 V or 300 V or 400 V or 500 V blocking voltage). In particular, exemplary transistor packages as disclosed herein may operate in the medium voltage (MV) range, in which the blocking voltage is equal to or greater than or less than 200 V or 150 V or 100 V or 50 V.

The (power) transistor chip 120 may be of different types. Examples described herein are, in particular, directed to HEMT (high electron mobility transistor) devices, for example. The semiconductor transistor chip(s) 120, 120_1, 120_2 disclosed herein may, e.g., be a III-V compound semiconductor chip having, e.g., a high band gap. The power transistor chip 120, 120_1, 120_2 may, e.g., be a GaN chip. In this case, the GaN chip 120, 120_1, 120_2 may be a lateral GaN-on-substrate device such as a GaN-on-Si device or a GaN-on-SiC device or a GaN-on-sapphire device, for example.

In all examples disclosed herein, the second leadframe (or structured metal plate) 160 may have a thickness equal to or greater than 150 um or 200 µm or 250 µm or 500 µm or 900 µm or 1.27 mm or 2.0 mm.

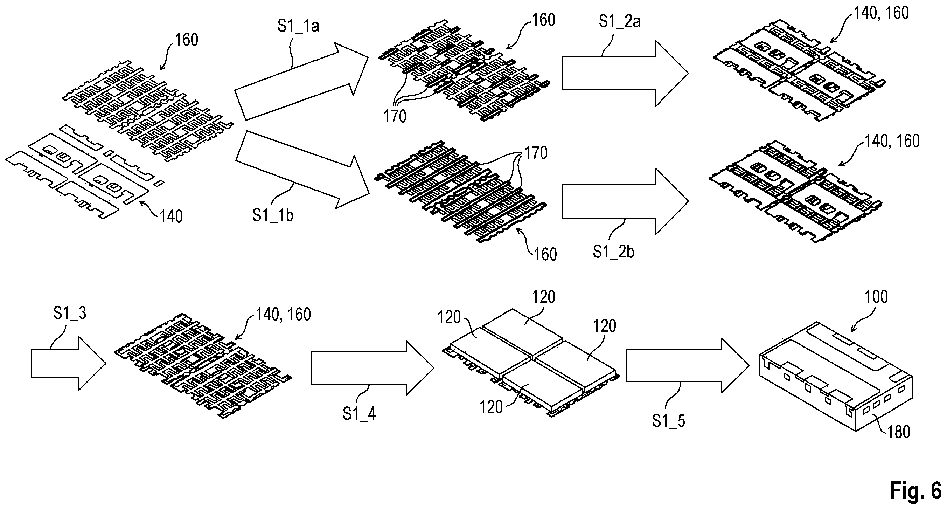

Figures 6 to 9 illustrate various exemplary methods of manufacturing a semiconductor chip package 100, 400. Referring to Figure 6, a first leadframe 140 and a second leadframe 160 are provided.

At S1_1a a bond material 170 is applied to the second leadframe 160. The bond material 170 applied at S1_1a may be a solder material, a conductive adhesive or a metal paste, for example.

Alternatively, at S1_1b, a bond material 170 suited for forming a diffusion solder connection may be applied to the second leadframe 160. The bond material applied at S1_1b is a diffusion solder material such as, e.g., NiSn or AuSn.

As apparent from Figure 6, the bond material 170 may be applied to each of the disconnected structures 160_1, 160_2, 160_3 (see Figure 1).

In other examples the bond material 170 may be applied to the first leadframe 140 rather than to the second leadframe 160.

At S1_2a the first leadframe 140 is attached to the second leadframe 160 by an appropriate attach process depending on the type of bonding material 170 used. For example, a reflow process (solder material) or a curing process (conductive adhesive) may be used.

At S1_2b the first leadframe 140 is soldered to the second leadframe 160 by diffusion soldering.

As a result of S1_2a or S1_2b, a stack of two interconnected leadframes 140, 160 is produced. The stack of leadframes 140, 160 may include a part of or all package internal re-routing from the chip pads 122_1, 122_2, 122_3 to the package terminal pads 140_1, 140_2, 140_3 or 440_1, 440_2, 440_3, 440_4, 440_5.

At S1_3 the stack of leadframes 140, 160 may be flipped. After S1_3 the second leadframe 160 is the top leadframe of the leadframe stack 140, 160.

At S1_4 one or a plurality of semiconductor chips 120 is attached to the stack of leadframes 140, 160. In the example shown, four semiconductor chips 120 are attached, for example. However, an arbitrary number of semiconductor chips 120 may be attached to the stack of leadframes 140, 160 depending on the size and outlay of the stack of leadframes 140, 160.

At S1_5 the first leadframe 140, the second leadframe 160 and the semiconductor chips 120 are embedded in a mold compound 180.

Moreover, S1_5 may include (optional) plating of package terminal pads 140_1-3, 440_1-5 and semiconductor chip package singulation.

The separation of the semiconductor chip package 100 may comprise separating (e.g. sawing) the molded body into the desired semiconductor chip packages 100, 400.

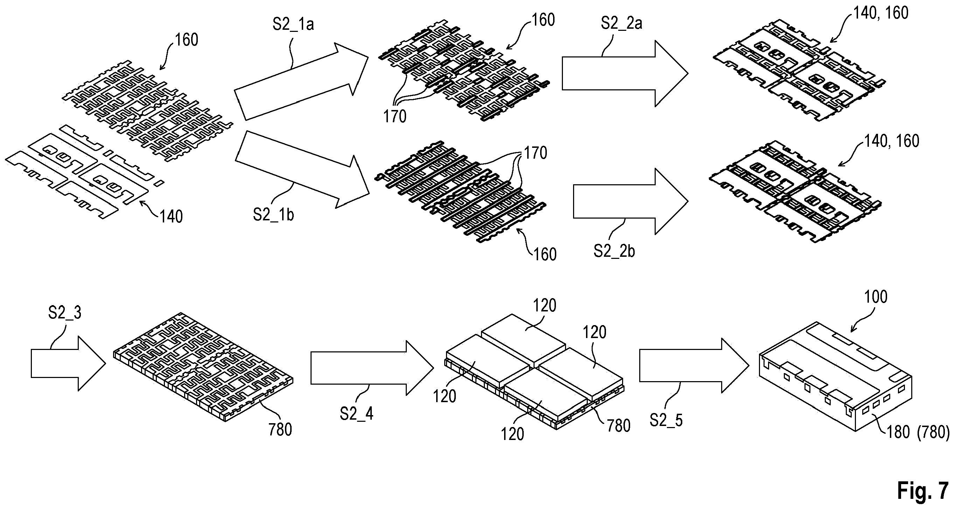

Figure 7 illustrates an example of another method of manufacturing semiconductor chip packages 100, 400. The method may start with the same processes as described above, i.e. S2_1a, S2_1b, S2_2a and S2_2b may correspond to S1_1a, S1_1b, S1_2a and S1_2b, respectively. Reference is made to the above description to avoid reiteration.

At S2_3, after bonding the first leadframe 140 to the second leadframe 160, the first leadframe 140 and the second leadframe 160 are embedded in a pre-mold compound 780.

S2_4 and S2_5 correspond to the processes S1_4 and S1_5, described above, and reference is made to the above description to avoid reiteration. More specifically, at S2_4 semiconductor chips 120 are attached to the pre-molded stack of leadframes 140, 160. S2_5 may include molding the pre-molded stack of leadframes 140, 160 to apply the final mold compound 180, optional plating and semiconductor chip package singulation as described in connection with S1_5.

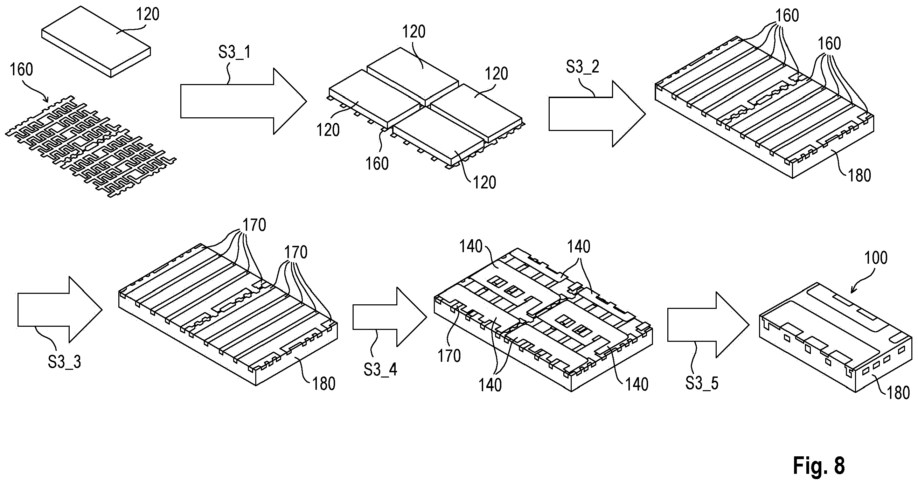

Figure 8 illustrates an example of another method of manufacturing semiconductor chip packages 100, 400. A second leadframe 160, and one or a plurality of semiconductor chips 120, are provided. At S3_1 one or a plurality of semiconductor chips 120 are attached to the second leadframe 160. Again, the semiconductor chips 120 are flip-chip attached, i.e. with their first side 120A (at which the chip pads 122_1, 122_2, 122_3 are located) to the second leadframe 160.

At S3_2 the second leadframe 160 and the semiconductor chips 120 are embedded in a mold compound 180. Figure 8 illustrates a view on the side of the mold compound 180 which faces the footprint of the later semiconductor chip package 100, 400.

At S3_3 a pattern of bond material 170 may be applied to the structures of the second leadframe 160 exposed at the mold compound 180. As described before, the bond material 170 may, e.g., be a conventional die-attach material (e.g., solder material, conductive adhesive, metal paste) or a Sn-based material such as, for example, diffusion soldering materials such as NiSn or AuSn. For example, applying a pattern of bond material at S3_3 may comprise a plating process. For example, all structures of the second leadframe 160 exposed at the mold compound 180 are completely plated.

At S3_4 the first leadframe 140 is bonded to the second leadframe 160.

At S3_5 an (optional) process of applying an underfill material to the footprint side of the semiconductor chip package 100, 400 may be carried out. The underfill material may be used to further protect (cover) the bond material areas at the footprint side of the semiconductor chip package 100, 400. The underfill material (not shown) may be applied by a dispenser along the recesses in the first leadframe 140 and may fill these recesses by capillary forces (i.e. without needing a second molding process) with an insulating polymer material, for example.

S3_5 may further include the processes of plating and semiconductor chip package singulation as described above in connection with S1_5 and S2_5.

Figure 9 illustrates an example of a method of manufacturing a semiconductor chip package 100, 400. A first leadframe 140 and a metal plate 960 may be provided. The metal plate 960 may be an unstructured, continuous metal plate, for example.

At S4_1 a pattern of bond material 170 may be applied between the first leadframe 140 structured to form a footprint of the semiconductor chip package 100, 400 and the metal plate 960. In the example shown, the bond material 170 is applied to the first leadframe 140, for example. Bond materials 170 as described above may be used.

At S4_2 the first leadframe 140 is bonded to the metal plate 960. Any of the above described processes may be used.

At S4_3 the first leadframe 140 is embedded in a pre-mold compound 980. Further, a mask layer is applied to a side of the metal plate 960 opposite the side at which the first leadframe 140 has been attached. The mask layer (e.g. photoresist layer) is structured to provide a structured mask layer 990, as shown in Figure 9. Structuring of the mask layer may be carried out by photolithography processes.

After patterning the metal plate 960 corresponding to the structured mask layer 990, the metal plate 960 is etched at S4_4. As a result, a structured metal plate 160 (corresponding to the second leadframe 160) is generated. Further, still at S4_4, the structured mask layer (e.g. photoresist) may be removed. That way, the structured metal plate 160 is exposed and ready for semiconductor chip attach.

Optionally, an underfill material may be applied between the recesses of the structured metal plate 160 as described previously.

At S4_5 one or a plurality of semiconductor chips 120 are attached with their chip pads to the structured metal plate 160 in flip-chip configuration.

At S4_6 the first leadframe 140, the structured metal plate 160 and the semiconductor chip(s) 120 are embedded in a mold compound 180. Further, semiconductor chip package singulation, as described above in connection with S1_5, S2_5, S3_5 may be performed.

For the examples in which a semiconductor transistor chip 120 is used, the face-down orientation of the transistor chip 120 in combination with the first leadframe-to-structured metal plate (or second leadframe) stack, which can be used as a routable base of the semiconductor chip package 100, 400, allows to align the semiconductor chip package footprint with the footprints of common MOSFET (Metal Oxide Semiconductor Field Effect Transistor) packages which, however, cannot fulfill the high current transport and/or fast switching requirements of the semiconductor chip packages 100, 400 described herein.

### EXAMPLES

The following examples pertain to further aspects of the disclosure:
Example 1 is a semiconductor chip package The semiconductor chip package includes a semiconductor chip having a first side and a second side opposite the first side. The first side includes chip pads. The semiconductor chip package includes a first leadframe structured to form a footprint of the semiconductor chip package. The semiconductor chip package further includes a structured metal plate disposed between the first leadframe and the semiconductor chip, wherein the first side of the semiconductor chip faces the structured metal plate. A pattern of bond material is disposed between the first leadframe and the structured metal plate. The pattern of bond material is configured to electrically and mechanically connect structures of the first leadframe to structures of the structured metal plate. The semiconductor chip package includes a mold compound embedding the first leadframe, the structured metal plate and the semiconductor chip.

In Example 2, the subject matter of Example 1 can optionally include wherein all chip pads of the semiconductor chip are disposed on the first side of the semiconductor chip.

In Example 3, the subject matter of Example 1 or 2 can optionally include wherein the semiconductor chip is a power chip, in particular a power transistor chip, more in particular a GaN transistor chip.

In Example 4, the subject matter of any of the preceding Examples can optionally include wherein the structured metal plate is a second leadframe.

In Example 5, the subject matter of any of the preceding Examples can optionally include wherein the pattern of bond material is formed of at least one of the group consisting of solder material, conductive adhesive, metal paste, or diffusion solder material.

In Example 6, the subject matter of any of the preceding Examples can optionally include wherein the first leadframe is structured to form a plurality of disconnected longitudinal segments extending in a first lateral direction, the structured metal plate is structured to form a plurality of disconnected longitudinal segments extending in a second lateral direction, the first lateral direction and the second lateral direction being different from each other.

In Example 7, the subject matter of any of the preceding Examples can optionally include wherein the chip package comprises a plurality of semiconductor chips and a structure of the first leadframe is connected via structures of the structured metal plate to chip pads of at least two semiconductor chips.

Example 8 is a method of manufacturing a semiconductor chip package. The method includes bonding a first leadframe structured to form a footprint of the semiconductor chip package to a second leadframe structured to align with chip pads of a semiconductor chip. A semiconductor chip having a first side and a second side opposite the first side, wherein the first side comprises chip pads, is attached with the chip pads to the second leadframe. The first leadframe, the second leadframe and the semiconductor chip are embedded in a mold compound.

In Example 9, the subject matter of Example 8 can optionally further include applying a pattern of bond material between the first leadframe and the second leadframe, wherein the pattern of bond material is configured to electrically and mechanically connect structures of the first leadframe to structures of the second leadframe.

In Example 10, the subject matter of Example 8 or 9 can optionally further include, after bonding the first leadframe to the second leadframe and before attaching the semiconductor chip to the second leadframe, embedding the first leadframe and the second leadframe in a pre-mold compound.

In Example 11 a method of manufacturing a semiconductor chip package. The method includes attaching a semiconductor chip having a first side and a second side opposite the first side, wherein the first side comprises chip pads, with the chip pads to a second leadframe. The second leadframe and the semiconductor chip are embedded in a mold compound. A first leadframe structured to form a footprint of the semiconductor chip package is bonded to the second leadframe.

In Example 12, the subject matter of Example 11 can optionally further include, after embedding the second leadframe and the semiconductor chip in the mold compound and before bonding the first leadframe to the second leadframe, applying a pattern of bond material between the first leadframe and the second leadframe, wherein the pattern of bond material is configured to electrically and mechanically connect structures of the first leadframe to structures of the second leadframe.

Example 13 is a method of manufacturing a semiconductor chip package. The method includes bonding a first leadframe structured to form a footprint of the semiconductor chip package to a metal plate. The first leadframe is embedded in a pre-mold compound. The metal plate is structured to provide a structured metal plate. A semiconductor chip having a first side and a second side opposite the first side, wherein the first side comprises chip pads, is attached with the chip pads to the structured metal plate. The first leadframe, the structured metal plate and the semiconductor chip are embedded in a mold compound.

In Example 14, the subject matter of Example 13 can optionally further include applying a pattern of bond material between the first leadframe and the metal plate, wherein the pattern of bond material is configured to electrically and mechanically connect structures of the first leadframe to zones of the metal plate corresponding to structures of the structured metal plate.

In Example 15, the subject matter of any of the Examples 8 to 14 can optionally include wherein the second leadframe or the metal plate has a thickness equal to or greater than 150 um or 200 µm or 250 µm or 500 µm or 900 µm or 1.27 mm or 2.0 mm.

In Example 16, the subject matter of any of the Examples 8 to 15 can optionally include wherein the first leadframe is structured to form a plurality of disconnected longitudinal segments extending in a first lateral direction, the second leadframe or the structured metal plate is structured to form a plurality of disconnected longitudinal segments extending in a second lateral direction, the first lateral direction and the second lateral direction being different from each other.

Although specific embodiments have been illustrated and described herein, it will be appreciated by those of ordinary skill in the art that a variety of alternate and/or equivalent implementations may be substituted for the specific embodiments shown and described without departing from the scope of the present invention. This application is intended to cover any adaptations or variations of the specific embodiments discussed herein. Therefore, it is intended that this invention be limited only by the claims and the equivalents thereof.

## Claims

1. A semiconductor chip package, comprising:
a semiconductor chip having a first side and a second side opposite the first side, wherein the first side comprises chip pads;
a first leadframe structured to form a footprint of the semiconductor chip package;
a structured metal plate disposed between the first leadframe and the semiconductor chip, wherein the first side of the semiconductor chip faces the structured metal plate;
a pattern of bond material disposed between the first leadframe and the structured metal plate, wherein the pattern of bond material is configured to electrically and mechanically connect structures of the first leadframe to structures of the structured metal plate; and
a mold compound embedding the first leadframe, the structured metal plate and the semiconductor chip.

2. The semiconductor chip package of claim 1, wherein all chip pads of the semiconductor chip are disposed on the first side of the semiconductor chip.

3. The semiconductor chip package of claim 1 or 2, wherein the semiconductor chip is a power chip, in particular a power transistor chip, more in particular a GaN transistor chip.

4. The semiconductor chip package of any of the preceding claims, wherein the structured metal plate is a second leadframe.

5. The semiconductor chip package of any of the preceding claims, wherein the pattern of bond material is formed of at least one of the group consisting of solder material, conductive adhesive, metal paste, or diffusion solder material.

6. The semiconductor chip package of any of the preceding claims, wherein the first leadframe is structured to form a plurality of disconnected longitudinal segments extending in a first lateral direction, the structured metal plate is structured to form a plurality of disconnected longitudinal segments extending in a second lateral direction, the first lateral direction and the second lateral direction being different from each other.

7. The semiconductor chip package of any of the preceding claims, wherein the chip package comprises a plurality of semiconductor chips and a structure of the first leadframe is connected via structures of the structured metal plate to chip pads of at least two semiconductor chips.

8. A method of manufacturing a semiconductor chip package, comprising:
bonding a first leadframe structured to form a footprint of the semiconductor chip package to a second leadframe structured to align with chip pads of a semiconductor chip;
attaching a semiconductor chip having a first side and a second side opposite the first side, wherein the first side comprises chip pads, with the chip pads to the second leadframe; and
embedding the first leadframe, the second leadframe and the semiconductor chip in a mold compound.

9. The method of claim 8, further comprising:
applying a pattern of bond material between the first leadframe and the second leadframe, wherein the pattern of bond material is configured to electrically and mechanically connect structures of the first leadframe to structures of the second leadframe.

10. The method of claim 8 or 9, further comprising:
after bonding the first leadframe to the second leadframe and before attaching the semiconductor chip to the second leadframe, embedding the first leadframe and the second leadframe in a pre-mold compound.

11. A method of manufacturing a semiconductor chip package, comprising:
attaching a semiconductor chip having a first side and a second side opposite the first side, wherein the first side comprises chip pads, with the chip pads to a second leadframe;
embedding the second leadframe and the semiconductor chip in a mold compound; and
bonding a first leadframe structured to form a footprint of the semiconductor chip package to the second leadframe.

12. The method of claim 11, further comprising:
after embedding the second leadframe and the semiconductor chip in the mold compound and before bonding the first leadframe to the second leadframe, applying a pattern of bond material between the first leadframe and the second leadframe, wherein the pattern of bond material is configured to electrically and mechanically connect structures of the first leadframe to structures of the second leadframe.

13. A method of manufacturing a semiconductor chip package, comprising:
bonding a first leadframe structured to form a footprint of the semiconductor chip package to a metal plate;
embedding the first leadframe in a pre-mold compound;
structuring the metal plate to provide a structured metal plate;
attaching a semiconductor chip having a first side and a second side opposite the first side, wherein the first side comprises chip pads, with the chip pads to the structured metal plate; and
embedding the first leadframe, the structured metal plate and the semiconductor chip in a mold compound.

14. The method of claim 13, further comprising:
applying a pattern of bond material between the first leadframe and the metal plate, wherein the pattern of bond material is configured to electrically and mechanically connect structures of the first leadframe to zones of the metal plate corresponding to structures of the structured metal plate.

15. The method of any of claim 8 to 14, wherein the second leadframe or the metal plate has a thickness equal to or greater than 150 um or 200 µm or 250 µm or 500 µm or 900 µm or 1.27 mm or 2.0 mm.

16. The method of any of claims 8 to 15, wherein the first leadframe is structured to form a plurality of disconnected longitudinal segments extending in a first lateral direction, the second leadframe or the structured metal plate is structured to form a plurality of disconnected longitudinal segments extending in a second lateral direction, the first lateral direction and the second lateral direction being different from each other.
